# EUROPÄISCHE PATENTSCHRIFT

(11) **EP 1 035 585 B1**
(45) Veröffentlichungstag und Bekanntmachung des Hinweises auf die Patenterteilung: **11.05.2011**
(21) Anmeldenummer: 00104774.5
(22) Anmeldetag: 06.03.2000
(51) Int. Cl.: H01L 23/66

(54) **Bondverbindung zwischen zwei Substraten**
Interconnection between two substrates
Interconnection entre deux substrats

(30) Priorität: 10.03.1999 DE 19910418
(43) Veröffentlichungstag der Anmeldung: 13.09.2000
(73) Patentinhaber: Ericsson AB, 164 80 Stockholm (SE)
(72) Erfinder: Kern, Stefan, 68753 Waghäusel (DE)
(74) Vertreter: Manitz, Finsterwald & Partner GbR

(56) Entgegenhaltungen:
- EP-A- 0 532 845
- NELSON S ET AL: "OPTIMUM MICROSTRIP INTERCONNECTS" MTT-S INTERNATIONAL MICROWAVE SYMPOSIUM DIGEST,US,NEW YORK, IEEE, Bd. -, 10. Juni 1991 (1991-06-10), Seiten 1071-1074, XP000260308

## Beschreibung

### Stand der Technik

Die vorliegende Erfindung betrifft eine Vorrichtung mit zwei auf benachbarten Substraten verlaufenden Streifenleitungen mit einer Bond-Verbindung zwischen den Streifenleitungen, wobei die Streifenleitungen mit vergrößerten, kapazitiv wirkenden Anschlußflächen enden und die Anschlußflächen beider Streifenleitungen über einen oder mehrere Bonddrähte miteinander kontaktiert sind.

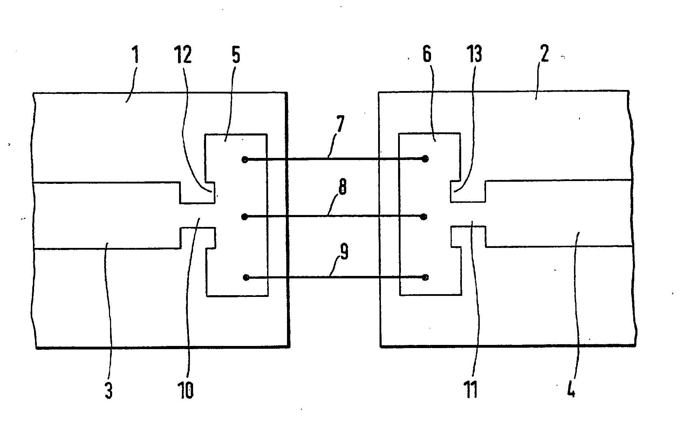

Eine solche Vorrichtung ist aus Fig. 2 der europäischen Patentanmeldung EP 0 532 845 A1 bekannt.

Bondverbindungen werden üblicherweise verwendet, um Verbindungen zwischen Mikrowellenschaltungen auf benachbarten, durch einen Spalt voneinander getrennten Substraten herzustellen. Bei Anwendungen im Hochfrequenzbereich (größer 10GHz) stellt sich das Problem, daß die Bonddrähte Induktivitäten darstellen, durch welche die Übertragungsbandbreite zwischen den beiden Substraten erheblich eingeschränkt wird. Um diesem Nachteil entgegenzuwirken, sind bei einer aus S. Nelson, M. Youngblood, J. Pavio, B. Larson, R. Kottman, "Optimum Microstrip Interconnects" IEEE MTT-S Digest, 1991, Seite 1071 bis 1074 bekannten Bondverbindung an den Enden der miteinander zu kontaktierenden Streifenleitungen vergrößerte, kapazitiv wirkende Anschlussflächen vorgesehen, die mit ein oder mehreren Bonddrähten kontaktiert sind. Diese kapazitiv wirkenden Anschlußflächen und die induktiv wirkenden Bonddrähte stellen ein Tiefpaßfilter mit einer π-Struktur dar. Durch entsprechende Wahl der Bonddrähte und Dimensionierung der Anschlußflächen läßt sich dieses Tiefpaßfilter so optimieren, daß es eine möglichst hohe obere Eckfrequenz aufweist. In der genannten Druckschrift ist eine Bondverbindung beschrieben, die für 15mil dicke Al₂O₃ Substrate und bis zu einer Frequenz von 18GHz bezüglich der Zahl der Bonddrähte und der Abmessungen der Anschlußflächen an den Streifenleitungen optimiert worden ist.

Bei noch höheren Frequenzen als 18GHz können die Bonddrähte und die Anschlußflächen nicht mehr als konzentrierte Induktivitäten und Kapazitäten betrachtet werden. Es treten dann parasitäre Wechselwirkungen zwischen den einzelnen Bauteilen auf, und es werden insbesondere an den Anschlußflächen für die Bonddrähte unerwünschte höhere Wellenmoden angeregt. Für diesen Fall läßt sich die Bondverbindung nicht mehr durch ein einfaches Tiefpaßfilter mit π-Struktur beschreiben. Ein weiteres Problem ergibt sich dadurch, daß die Übertragungseigenschaften der Bondverbindung sehr stark von den Abmessungstoleranzen der Anschlußflächen und der Bonddrähte abhängen.

Der Erfindung liegt daher die Aufgabe zugrunde, eine Bondverbindung der eingangs genannten Art anzugeben, die insbesondere bei sehr hohen Frequenzen über ein möglichst breites Frequenzband gute Anpassungs- und Übertragungseigenschaften aufweist.

### Vorteile der Erfindung

Die genannte Aufgabe wird mit den Merkmalen des Anspruchs 1 gelöst. Vor den Anschlußflächen der Streifenleitungen ist jeweils ein induktiv wirkendes Leitungsstück mit einer geringeren Leiterbreite als die der Streifenleitung eingefügt. Diese induktiv wirkenden verengten Leitungsstücke bewirken auch eine Unterdrückung von störenden höheren Wellenmoden. Es soll darauf hingewiesen werden, daß aus Fig. 5 der EP 0 532 845 A1 eine Vorrichtung mit zwei durch eine Bondverbindung verbundenen Streifenleitungen bekannt ist, bei der an dem Ende einer der Streifenleitungen ein Leitungsstück mit einer gegenüber der Leiterbreite der Streifenleitung verringerten Leiterbreite vorgesehen ist.

Wie aus dem Anspruch hervorgeht, sind die Anschlußflächen für die Bonddrähte mit Einschnitten versehen, in welche die verengten Leitungsstücke hineinverlaufen und darin auf die Anschlußflächen übergehen.

Die erfindungsgemäße Vorrichtung erreicht eine Anpassung, die bis zu 27GHz größer als 20dB ist, wobei zwischen den beiden Substraten ein relativ großer Abstand von 100 bis 300µm besteht und die Bonddrähte zwischen 680 und 780µm lang sind. Die Abstrahlung dieser Bondverbindung ist geringer als 3% der übertragenen Leistung. Die guten Anpassungseigenschaften können bis zu 35GHz mit relativ geringen Abmessungstoleranzen erreicht werden.

### Beschreibung eines Ausführungsbeispiels

Die Figur der Zeichnung zeigt eine Draufsicht auf zwei gegenseitig beabstandete Substrate (z.B. Al₂O₃-Substrate) 1 und 2. Die Substrate 1 und 2 dienen als Träger für, in der Zeichnung nicht dargestellte, Mikrowellenschaltungen. Auf den Substraten 1 und 2 ist jeweils eine zu den Mirkowellenschaltungen führende Streifenleitung 3 und 4 dargestellt. Die beiden Streifenleitungen 3 und 4 sollen elektrisch miteinander verbunden werden, so daß eine möglichst breitbandige Signalübertragung möglich ist. Dazu endet jede Streifenleitung 3, 4 in einer Anschlußfläche 5, 6, und mit den beiden Anschlußflächen 5 und 6 sind die Enden von drei den Spalt zwischen den beiden Substraten 1 und 2 überbrückenden Bonddrähten 7, 8 und 9 kontaktiert. Je nach zu erzielender Übertragungseigenschaft können noch mehr oder auch weniger als drei Bonddrähte verwendet werden. Die Bonddrähte 7, 8 und 9 haben induktive Eigenschaften. Zur Kompensation dieser Induktivitäten dienen die Anschlußflächen 5 und 6, deren Abmessungen so gewählt sind, daß deren kapazitive Eigenschaften die induktiven der Bonddrähte 7, 8 und 9 kompensieren.

Bei sehr hohen Frequenzen (größer als 20GHz) entstehen an den relativ großflächigen Anschlußflächen 5 und 6 unerwünschte höhere Wellentypen, welche die Übertragungseigenschaften der Bondverbindung verschlechtern. Um eine Ausbreitung der höheren Wellentypen zu unterdrücken, sind jeweils zwischen der Mikrostreifenleitung 3, 4 und der zugehörigen Anschlußfläche 5, 6 induktiv wirkende Leitungsstücke 10, 11 eingefügt, die eine geringere Leiterbreite als die Streifenleitungen 3, 4 aufweisen. Diese zusätzlichen Leitungsstücke 10 und 11 wirken also wie Mode-Filter, die eine Ausbreitung der höheren Moden verhindern.

Eine weitere Verbesserung der breitbandigen Anpassungs- und Übertragungseigenschaften der Bondverbindung wird durch Einschnitte 12 und 13 in den Anschlußflächen 5 und 6 in der Umgebung der verengten Leitungsstücke 10 und 11 erzielt, welche in die Einschnitte 12 und 13 hineinverlaufen und darin auf die Anschlußflächen 5 und 6 übergehen. Die Breite der Einschnitte 12 und 13 entpricht vorzugsweise in etwa der Breite der Mikrostreifenleitungen 3 und 4. Die Tiefe der Einschnitte 12 und 13 ist je nach der Betriebsfrequenz zu optimieren.

Um optimale Anpassungs- und Übertragungseigenschaften der Bondverbindung zu erzielen, müssen in einem Optimierungsprozeß die Länge und Breite der zusätzlichen Leitungsstücke 10, 11, die Länge und Breite der Anschlußflächen 5, 6, die Breite und Tiefe der Einschnitte 12 und 13 und die Länge der Bonddrähte 7, 8, 9 unter Berücksichtigung der Betriebsfrequenz und des Materials, der Dicke und des Abstandes der beiden Substrate 1 und 2 dimensioniert werden.

## Patentansprüche

1. Vorrichtung mit zwei auf benachbarten Substraten (1, 2) verlaufenden Streifenleitungen (3, 4) mit einer Bond-Verbindung zwischen den Streifenleitungen (3, 4), wobei die Streifenleitungen (3, 4) mit vergrößerten, kapazitiv wirkenden Anschlußflächen (5, 6) enden und die Anschlußflächen (5, 6) beider Streifenleitungen (3, 4) über einen oder mehrere Bonddrähte (7, 8, 9) miteinander kontaktiert sind, **dadurch gekennzeichnet, daß** vor den Anschlußflächen (5, 6) der Streifenleitungen (3, 4) jeweils ein induktiv wirkendes Leitungsstück (10, 11) mit einer geringeren Leiterbreite als die der Streifenleitungen (3, 4) eingefügt ist und daß die Anschlußflächen (5, 6) mit Einschnitten (12, 13) versehen sind, in welche die Leitungsstücke (10, 11) hineinverlaufen und darin auf die Anschlußflächen (5, 6) übergehen.

## Claims

1. An apparatus comprising two strip lines (3, 4) extending on adjacent substrates (1, 2) with a bond interconnection between them, wherein the strip lines (3, 4) end with enlarged connector areas (5, 6) having a capactive effect and wherein the connector areas (5, 6) of both strip lines (3, 4) are mutually contacted via one or more bond wires (7, 8, 9),
**characterised in that**
a respective inductively acting line piece (10, 11) is inserted before the connector areas (5, 6) of the strip lines (3, 4) and has a smaller line width than the line width of the strip lines (3, 4); and
**in that** the connector areas (5, 6) exhibit recesses (12, 13) into which the line pieces (10, 11) extend and in which they join the connector areas (5, 6).

## Revendications

1. Dispositif comprenant deux lignes en forme de rubans (3, 4) s'étendant sur des substrats voisins (1, 2) avec une liaison à bande entre les lignes en forme de rubans (3, 4), lesdites lignes en forme de rubans (3, 4) se terminant par des surfaces de raccordement (5, 6) agrandies avec effet capacitif, et les surfaces de raccordement (5, 6) des deux lignes en forme de rubans (3, 4) étant mises en contact les unes avec les autres via un ou plusieurs fils de bonding (7, 8, 9),
**caractérisé en ce qu'**un morceau de ligne (10, 11) à effet inductif présentant une largeur de ligne plus faible que celle des lignes en forme de rubans (3, 4) est inséré devant les surfaces de raccordement (5, 6) des lignes en forme de rubans (3, 4), et **en ce que** les surfaces de raccordement (5, 6) sont pourvues d'entailles (12, 13) dans lesquelles les morceaux de ligne (10, 11) s'étendent en pénétration, et se transforment dans celles-ci pour donner les surfaces de raccordement (5, 6).
